**Europäisches Patentamt**

**European Patent Office**

**Office européen des brevets**

(19)

(11) Veröffentlichungsnummer: **0 144 950**

**A2**

(12) # EUROPÄISCHE PATENTANMELDUNG

(21) Anmeldenummer: **84114650.9**

(22) Anmeldetag: **03.12.84**

(51) Int. Cl.⁴: **G 02 B 17/06**
**G 01 J 3/02, G 01 J 3/44**
**G 01 N 21/64**

(30) Priorität: **03.12.83 DE 3343868 U**

(43) Veröffentlichungstag der Anmeldung:
**19.06.85 Patentblatt 85/25**

(84) Benannte Vertragsstaaten:
**CH DE FR GB LI**

(71) Anmelder: **Firma Carl Zeiss**

**D-7920 Heidenheim (Brenz)(DE)**

(84) Benannte Vertragsstaaten:
**CH DE FR LI**

(71) Anmelder: **CARL-ZEISS-STIFTUNG Trading as CARL ZEISS**

**D-7920 Heidenheim (Brenz)(DE)**

(84) Benannte Vertragsstaaten:
**GB**

(72) Erfinder: **Mächler, Meinrad**
**Sulzgasse 2**
**D-7090 Ellwangen(DE)**

(72) Erfinder: **Schlemmer, Harry Dr. Dipl.-Phys**
**Albrecht-Erhardt-Strasse 17**
**D-7080 Aalen(DE)**

(72) Erfinder: **Glück, Franz, Dipl.-Phys.**
**Eichweg 27**
**D-7080 Aalen(DE)**

(72) Erfinder: **Bittner, Reinhold, Dipl.-Math**
**Friedenstrasse 6**
**D-7074 Mögglingen(DE)**

(54) **Objektiv mit Kegelschnittflächen für die Mikrozonenabbildung.**

(57) Für die Abbildung von kleinen Bereichen mit großem Öffnungswinkel werden Objektive angegeben, die aus zwei Kegelschnittkörpern (z.B. 1a, 1b, 6a, 6b) aus optisch isotropen Material bestehen und bei denen die Ablenkung der Lichtstrahlen durch Totalreflektion an den Mantelflächen (z.B. 10, 15, 60, 65) erfolgt. Die Lichtein- und austrittsflächen sind als Kugelflächen (z.B. 13, 18, 63, 68) ausgebildet, deren Mittelpunkte (z.B. 14, 19, 64, 69) mit den Brennpunkten (z.B. 11, 16, 61, 66) der Kegelschnittkörper mindestens annähernd in einem Punkt vereinigt sind.

Fig.1

EP 0 144 950 A2

0144950
83042 P EP

Objektiv mit Kegelschnittflächen für die Mikrozonenabbildung

Die vorliegende Erfindung betrifft ein Objektiv mit reflektierenden Kegelschnittflächen. Das Anwendungsgebiet liegt vorzugsweise bei Spektrometern, insbesondere bei Simultanspektrometern mit Diodenzeilen. Das erfindungsgemäße Spiegelobjektiv ist jedoch auch für andere Anwendungsgebiete geeignet, bei denen Mikrozonen mit großer Öffnung abgebildet werden.

Simultanspektrometer mit Diodenzeilen sind in den letzten Jahren für zahlreiche Anwendungsgebiete bekannt geworden (siehe z.B. GIT Fachz. Lab. Heft 3, 1983, S. 170; Markt & Technik Nr. 49 vom 04.12.1981, S. 52; Prospekt der Fa. Carl Zeiss W 90-100-d; Prospekt der Fa. Hewlett Packard Nr. 23-5953-8032 GE). Die wesentlichen Vorteile dieser Spektrometer bestehen in ihrer sehr kompakten Bauform und der Geschwindigkeit, mit der ein ganzes Spektrum gemessen wird.

Aus der DE-OS 32 15 879 ist ein Diodenzeilen-Spektrometer bekannt, welches die Spektrenmessung in der Blutbahn mit einer Lichtleitersonde ermöglicht. Dabei hat das Spektrometer ein Öffnungsverhältnis, das die Apertur des Lichtleiters ohne Beschnitt aufnimmt. Auch bei Spektrometern mit integriertem Probenraum ist es aus energetischen Gründen vorteilhaft, das Öffnungsverhältnis groß zu machen. Das ist durch die Verwendung von holografischen Konkavgittern durchaus möglich; man benötigt dann jedoch für den Probenraum abbildende Optik für das gleiche, große Öffnungsverhältnis. Diese Optik sollte für den gesamten interessierenden Spektralbereich von 200 bis 1100 nm geeignet sein, wobei infolge der kleinen Abmessungen der Empfängerflächen der Diodenzeile die Abbildung von kleinen Bereichen, sog. Mikrozonen, ausreichend ist. In den meisten Fällen ist ein Abbildungsverhältnis von nahezu oder gleich 1:1 angebracht; die Energieverluste durch Reflexion an den Grenzflächen sollte im gesamten Spektralbereich möglichst gering sein.

Auf dem Gebiet der Mikroskopie sind zwar zahlreiche Objektive bekannt, die ein großes Öffnungsverhältnis haben. Diese Objektive haben aber nur einen begrenzten Wellenlängenbereich; sie sind außerdem für starke Vergrößerung ausgelegt. Konventionelle Objektive müßten für einen Wellenlängenbereich bis 200 nm aus vielen Gliedern bestehen; sie wären daher teuer und hätten einen geringen Durchlaßgrad.

Aus der Mikroskopie sind auch Spiegelobjektive bekannt (siehe z.B. H.Riesenberg, Jenaer Jahrbuch 1956, S.30), bei denen der Strahlengang zwischen den beiden Spiegeln in einem festen durchlässigen Körper (Glas, Quarz o.ä.) verläuft, dessen Ein- und Austrittsflächen konzentrisch zum Objekt- bzw. Bildort liegen, so daß die Lage des Bildortes von der benutzten Wellenlänge unabhängig ist. Der Nachteil dieser Spiegelobjektive besteht darin, daß sie nicht für sehr große Aperturen geeignet sind, wenn das Objekt im Luftraum liegt, daß sie einen verhältnismäßig großen Durchmesser haben und vor allem, daß die Reflexionsverluste an den rückseitig verspiegelten Glasflächen insbesondere im UV groß sind.

In einer Veröffentlichung von Mertz (Applied Optics 20, 1127 (1981)) ist ein Spiegelobjektiv angegeben, das aus zwei ellipsoidförmigen Hohlkörpern besteht, deren Brennpunkte auf der optischen Achse liegen, wobei die inneren Brennpunkte zusammenfallen. Wenn die Ellipsoide gleich groß sind, erfolgt eine Abbildung im Maßstab 1:1, die aplanatisch ist. In einer weiteren Veröffentlichung von Mertz (Applied Optics 18, 4182 (1979)) ist ein Mikroskopobjektiv aus zwei rotationssymmetrischen Hohlkörpern angegeben, das eine 10-fache Vergrößerung hat. Wenn das System wie angegeben aplanatisch ist, dürfte es sich jedoch nicht um ein Doppelellipsoidsystem handeln, was auch aus den (schlecht erkennbaren) Strahlenverläufen in Fig. 10 hervorgeht. Die beschriebenen Doppelsysteme mit asphärischen Innenflächen haben die Nachteile, daß asphärische Innenflächen sehr schwer herzustellen sind, daß bei der Reflexion an diesen Innenflächen insbesondere bei großen Einfallswinkeln starke Polarisation eintritt, daß verhältnismäßig hohe Reflexionsverluste entstehen und daß die notwendige Ausblendung der inneren Apertur mit mechanischem Aufwand verbunden ist.

Der vorliegenden Erfindung liegt daher die Aufgabe zugrunde, ein Objektiv anzugeben, das mit großem Öffnungwinkel einen kleinen Bereich im Maßstab nahe oder gleich 1:1 mit geringen Fehlern abbildet und dabei im gesamten Wellenlängenbereich von 200 bis 1100 nm eine möglichst große Durchlässigkeit hat.

Die gestellte Aufgabe wird bei einem Spiegelobjektiv mit reflektierenden Kegelschnittflächen dadurch gelöst, daß die reflektierenden Kegelschnittflächen Mantelflächen von optisch isotropen Kegelschnittkörpern sind und daß die Lichtein- und austrittsflächen der Kegelschnittkörper Kugelflächen sind, deren Mittelpunkte mit den Brennpunkten der Kegelschnittkörper mindestens annähernd in einem Punkt vereinigt sind.

Durch die Ausbildung der Kegelschnittflächen als Mantelflächen von optisch isotropen Kegelschnittkörpern tritt an den Kegelschnittflächen Totalreflexion ein, so daß sehr geringe Verluste entstehen und eine große Durchlässigkeit erreicht wird. Dabei benötigen die Mantelflächen infolge der angrenzenden Luft keinen Belag, da die Halterung der Kegelschnittkörper außerhalb der optisch wirksamen Mantelflächen erfolgen kann. Für den geforderten Wellenlängenbereich von 200 bis 1100 nm können die Kegelschnittkörper z.B. aus Flußspat oder Quarzglas sein.

In einer vorteilhaften Ausführungsform sind beide Kegelschnittkörper Ellipsoide, deren Brennpunkte auf einer Achse angeordnet sind und deren innere Brennpunkte mindestens annähernd in einem Punkt vereinigt sind. Wenn beide Ellipsoide die gleiche numerische Exzentrizität haben, ist der Abbildungsmaßstab 1:1, und die Abbildung des einen äußeren Brennpunktes in den anderen äußeren Brennpunkt ist aplanatisch. Eine gute Abbildung erhält man auch noch für kleine Bereiche um die äußeren Brennpunkte in den Ebenen senkrecht zur optischen Achse. Bei einem Abbildungsmaßstab 1:1 sind die inneren Brennpunkte in einem Punkt vereinigt. Für andere Abbildungsmaßstäbe kann es zur Korrektur der Abbildungsfehler günstig sein, die inneren Brennpunkte etwas auseinanderzulegen, wie später noch dargestellt wird.

In einer anderen vorteilhaften Ausführungsform sind die Kegelschnittkörper ein Ellipsoid und ein Paraboloid, deren Brennpunkte auf einer Achse angeordnet sind, wobei der Brennpunkt des Paraboloides mit einem Brennpunkt des Ellipsoides in einem Punkt vereinigt ist. Dabei liegt der Mittelpunkt der äußeren Kugelfläche des Paraboloides im Unendlichen, d.h. die äußere Begrenzungsfläche des Paraboloides ist eben.

Aus fertigungstechnischen Gründen kann es vorteilhaft sein, die beiden Kegelschnittkörper nicht aus einem Stück herauszuarbeiten. Wenn trotzdem eine kompakte Bauform nützlich ist, können die beiden einzeln hergestellten Kegelschnittkörper miteinander verkittet oder aneinander angesprengt werden.

Die beiden Kegelschnittkörper können auch vom einem kugelförmigen Luftzwischenraum getrennt sein, dessen Mittelpunkt mit den inneren Brennpunkten der Kegelschnittkörper mindestens annähernd in einem Punkt vereinigt ist.

In einer vorteilhaften Ausführungsform ist zwischen den beiden Kegelschnittkörpern eine Kugel aus optisch isotropen Material angeordnet, deren Mittelpunkt mit den inneren Brennpunkten der Kegelschnittkörper mindestens annähernd in einem Punkt vereinigt ist.

Besonders vorteilhaft ist es, die Kugel aus einem Material zu machen, dessen Brechzahl größer ist als die Brechzahl der Kegelschnittkörper. Durch eine derartige Kugel, z.B. aus Saphir, lassen sich Punkte einer zur optischen Achse senkrechten Objektebene, die durch einen äußeren Brennpunkt geht oder in dessen Nähe liegt, mit einem wesentlich kleineren Zerstreuungskreis und mit einer kleineren Bildfeldkrümmung abbilden, als dies bei einer homogenen Verbindung der Ellipsoide der Fall ist.

In einer anderen vorteilhaften Ausführungsform der vorliegenden Erfindung sind die Kegelschnittkörper zwei Paraboloidausschnitte, deren Achsen zur optischen Achse des Abbildungssystemes geneigt sind, wobei die Mittelpunkte der äußeren Kugelflächen zugleich die Brennpunkte der Paraboloidausschnitte sind. Die Mittelpunkte der inneren Kugelflächen liegen im Unendlichen und zwischen den Paraboloidausschnitten ist eine gerade Anzahl von Planspiegeln so angeordnet, daß sich das in das Planspiegelsystem ein- und austretende parallele Strahlenbündel kreuzt. Durch eine derartige Anordnung der reflektierenden Planspiegel erhält das Gesamtsystem gute Abbildungseigenschaften.

In einer weiteren Ausgestaltung der Erfindung ist mindestens ein Teil der Planspiegel mit Filterschichten belegt. Da diese im telezentrischen Teil des Strahlenganges liegen, können auch sehr schmalbandige Interferenz-Mehrfachschichtfilter verwendet werden.

Weitere Ausgestaltungen der Erfindung gehen aus den Unteransprüchen hervor.

Ein besonderer Vorteil der verwendeten Kegelschnittflächen gegenüber anderen asphärischen Flächen besteht darin, daß sie auf relativ einfache Weise auch während des Herstellungsprozesses optisch geprüft werden können.

Ein weiterer Vorteil der Objektive aus zwei Ellipsoiden besteht darin, daß die Lage des Objektives zwischen Objekt- und Bildebene weitgehend frei wählbar ist, da der Abbildungsmaßstab nur durch das Verhältnis der numerischen Exzentrizitäten beeinflußt wird und damit die Schnittweiten durch die Größe der Ellipsoide noch in weitem Maße frei gewählt werden können.

Die Erfindung wird im folgenden an Hand von in den Figuren 1 bis 8b dargestellten Asuführungs- und Anwendungsbeispielen näher erläutert. Dabei zeigen:

Fig. 1    ein Objektiv aus zwei gleichen Ellipsoiden;

Fig. 2    ein anderes Objektiv aus zwei gleichen Ellipsoiden;

Fig. 3    ein Objektiv aus zwei verschiedenen Ellipsoiden mit einem Abbildungsmaßstab 3:1;

Fig. 4a   ein Objektiv aus zwei Ellipsoiden für die Abbildung aus oder nach Unendlich;

Fig. 4b   ein Objektiv aus einem Ellipsoid und einem Paraboloid für die Abbildung aus oder nach Unendlich;

Fig. 5a   ein Objektiv, das aus zwei Ellipsoiden besteht, welche aneinander angesprengt sind,

Fig. 5b   ein Objektiv mit einem kugelförmigen Luftzwischenraum;

Fig. 5c   ein Objektiv mit einer Kugel zwischen den Kegelschnittkörpern;

Fig. 6a   ein Objektiv aus zwei Paraboloiden mit zwei reflektierenden Flächen zwischen den Paraboloiden;

Fig. 6b   ein Objektiv aus zwei Paraboloiden mit vier reflektierenden Flächen zwischen den Paraboloiden;

Fig. 7    ein Beispiel für die Anwendung von zwei Objektiven im Probenraum eines Spektrometers;

Fig. 8a   ein Beispiel für die Anwendung von einem Objektiv im Probenraum eines Fluoreszenz-Spektrometers und

Fig. 8b   ein Beispiel für die Anwendung von zwei verschiedenen Objektiven im Probenraum eines Ramanspektrometers.

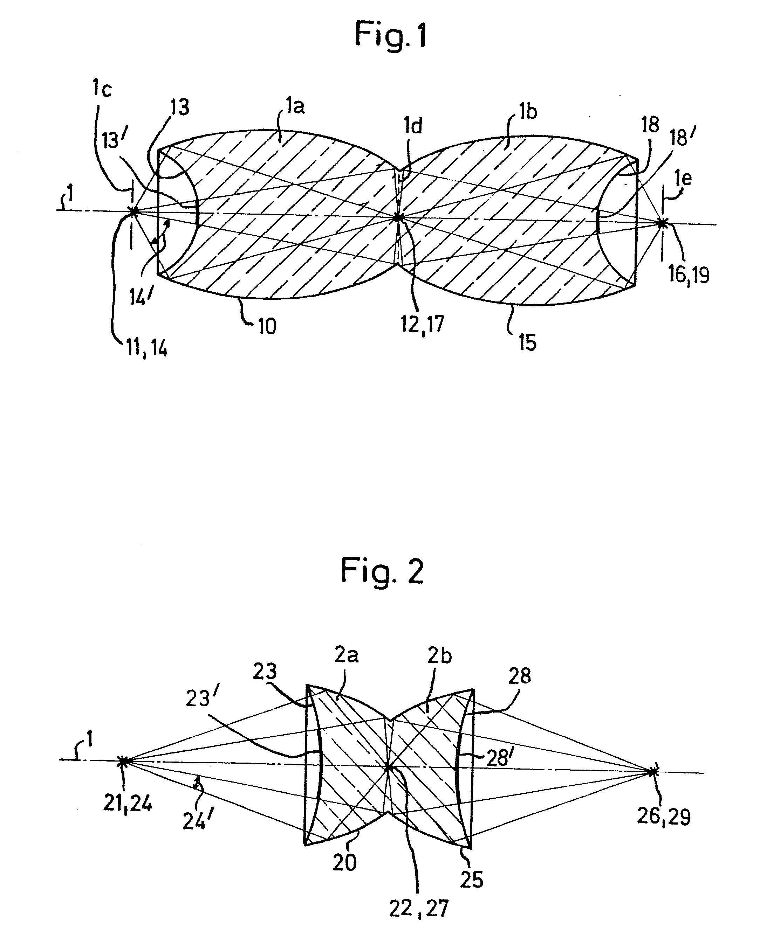

In Fig. 1 ist ein Objektiv für den Abbildungsmaßstab 1:1 dargestellt. Es besteht aus den Ellipsoiden 1a und 1b, welche die gleichen Abmessungen haben und aus optisch isotropen Material sind. Auf ihrer gemeinsamen Achse 1 liegen die Brennpunkte 11 und 12, sowie 16 und 17. Die Ellipsoide sind so zueinander angeordnet daß der Brennpunkt 12 des Ellipsoides 1a mit dem Brennpunkt 17 des Ellipsoides 1b zusammenfällt. Die äußeren Stirnflächen 13 und 18 sind als Kugelschalen mit den Mittelpunkten 14 und 19 ausgebildet. Im dargestellten Ausführungsbeispiel für den Abbildungsmaßstab 1:1 fallen der Mittelpunkt 14 der Kugelschale 13 mit dem Brennpunkt 11 des Ellipsoides 1a und der Mittelpunkt 19 der Kugelschale 18 mit dem Brennpunkt 16 des Ellipsoides 1b zusammen.

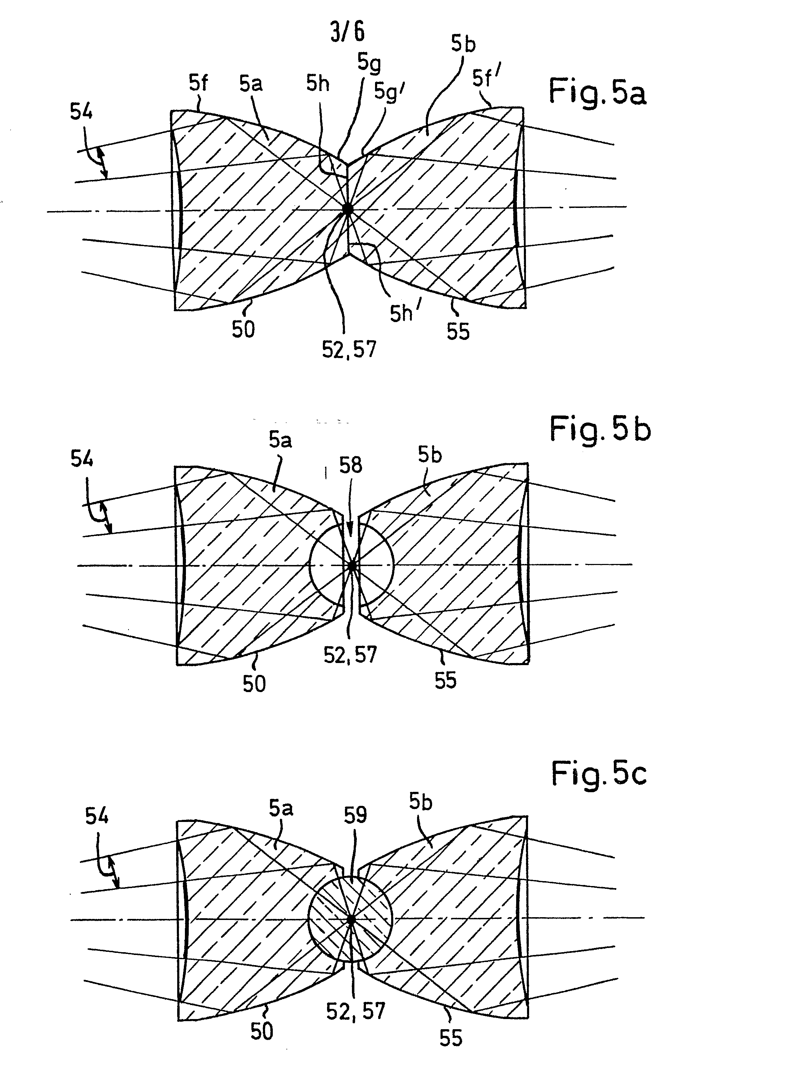

Die Objektebene 1c geht senkrecht zur Achse 1 durch die Punkte 11 bzw. 14; die Bildebene 1e geht senkrecht zur Achse 1 durch die Punkte 16 bzw. 19. Es ist klar, daß der Brennpunkt 11 durch die elliptische Mantelfläche 10 in den Brennpunkt 12 bzw. 17 und dieser durch die elliptische Mantelfläche 15 in den Brennpunkt 16 exakt abgebildet wird. Dagegen wird ein in der Objektebene 1c beliebig nah am Brennpunkt 11 liegender Punkt in der Zwischenebene 1d nicht als Punkt abgebildet, da die von verschiedenen Zonen der elliptischen Mantelfläche 10 reflektierten Strahlen die Zwischenebene 1d an unterschiedlichen Stellen treffen. Diese Zonenfehler werden jedoch von dem zweiten Ellipsoid 1b, das die gleichen Abmessungen hat wie das Ellipsoid 1a, für einen nicht zu weit von der Achse 1 entfernten Punkt weitgehend kompensiert, so daß sich die Strahlen in der Bildebene 1e wieder praktisch in einem Punkt schneiden. Die auftretenden Abweichungen machen sich insbesondere in einer Bildfeldkrümmung bemerkbar. Auf diese wird bei den Erläuterungen zu den Figuren 5a und b näher eingegangen.

Es ist selbstverständlich, daß keine Strahlen von der Bildebene 1c ohne Reflexionen an den elliptischen Mantelflächen zur Objektebene 1e gehen dürfen, weil sie nicht zur Abbildung beitragen, sondern zu einer Kontrastverminderung führen würden. Deswegen ist auf die Kugelfläche 13 eine Blende 13', z.B. in bekannter Weise durch Aufdampfen, aufgebracht, welche die innere Apertur ausblendet, so daß nur die äußere, ringförmige Apertur 14' ausgenutzt wird. Die Blende 18' dient zur Abschirmung von Streulicht, das innerhalb der beiden Ellipsoide 1a und 1b entstehen kann.

Die Reflexion an den elliptischen Mantelflächen 10 und 15 erfolgt innerhalb der gesamten Bereiche durch Totalreflektion. Dies hat nicht nur den Vorteil, daß auf aufgebrachte, reflektierende Schichten verzichtet werden kann, sondern auch, daß praktisch keine Verluste entstehen, und dies im gesamten Wellenlängenbereich. Außerdem wird eine Polarisation der Strahlung weitestgehend vermieden. Dazu muß nur dafür gesorgt werden, daß innerhalb der ausgenutzten Bereiche der Mantelflächen 10 und 15 nur Luft die Flächen begrenzt; die Halterung der Ellipsoide 1a und 1b erfolgt daher außerhalb der optisch ausgenutzten Bereiche.

Fig. 2 zeigt ein weiteres Objektiv für den Abbildungsmaßstab 1:1 mit kleinerer Apertur und dafür größeren Schnittweiten. Die Ellipsoide sind mit 2a und 2b bezeichnet, ihre Mantelflächen mit 20 und 25. Alle Brennpunkte liegen auf der Achse 1, wobei der innere Brennpunkt 22 des Ellipsoides 2a mit dem inneren Brennpunkt 27 des Ellipsoides 2b zusammenfällt. Der äußere Brennpunkt 21 fällt mit den Mittelpunkt 24 der konzentrischen Kugelfläche 23 und der äußere Brennpunkt 26 fällt mit dem Mittelpunkt 29 der Kugelfläche 28 zusammen. Mit 23' und 28' sind die Blenden für die innere Apertur und mit 24' ist die ausgenutzte äußere Ringapertur bezeichnet.

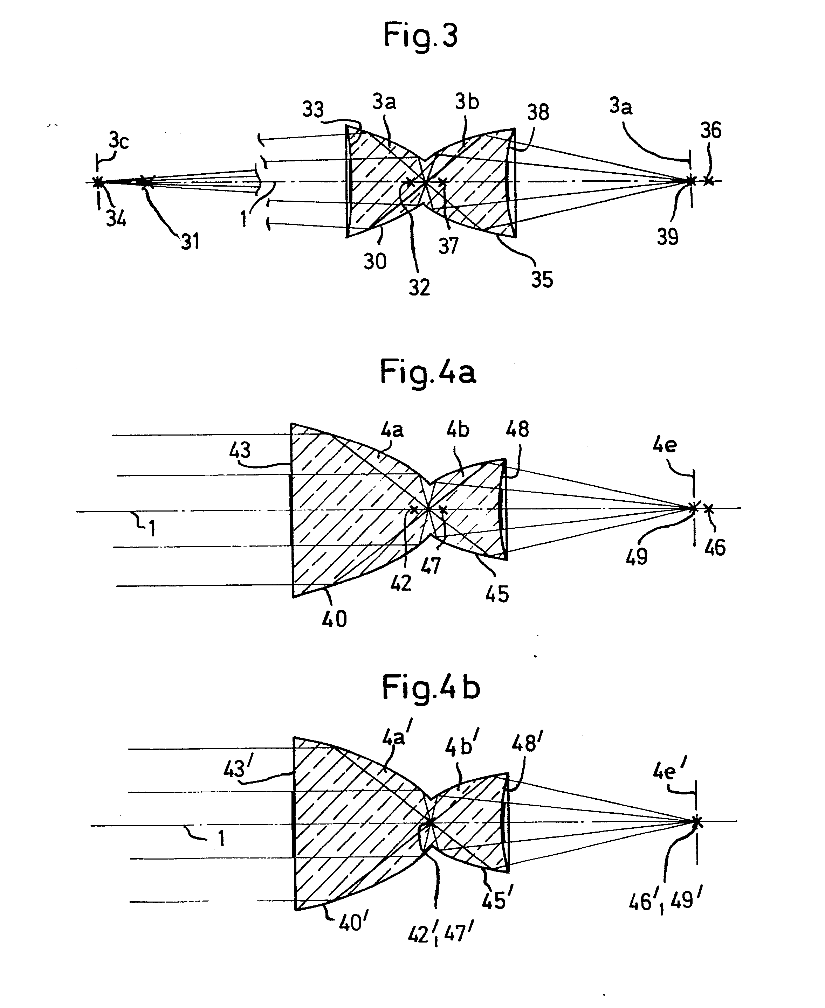

In Figur 3 ist ein Objektiv für den Abbildungsmaßstab 3:1 dargestellt. Es besteht aus den Ellipsoiden 3a und 3b mit den Mantelflächen 30 und 35. Infolge des von 1:1 abweichenden Abbildungsmaßstabes ist das System nicht mehr aplanatisch. Für die Abbildungseigenschaften ist es daher vorteilhaft, den Brennpunkt 32 des Ellipsoides 3a und den Brennpunkt 37 des Ellipsoides 3b nicht zusammen zu legen. Ihr Abstand ist in Figur 3 stark vergrößert dargestellt; er liegt in der Größenordnung von μm. Erheblich größer sind die Abstände zwischen Objekt- und Bildebene bzw. den Mittelpunkten der Kugelflächen und den entsprechenden Brennpunkten. Zwischen der Objektebene 3c, welche durch den Mittelpunkt 34 der Kugelfläche 33 geht, und dem äußeren Brennpunkt 31 des Ellipsoides 3a beträgt der Abstand einige mm; zwischen der Bildebene 3e, welche durch den Mittelpunkt 39 der Kugelfläche 38 geht, und dem äußeren Brennpunkt 36 des Ellipsoides 3b beträgt der Abstand ca. 0,5 mm bei dem im Maßstab 1:1 in Figur 3 dargestellten System. Genauere Angaben folgen nach den Erläuterungen zu den Figuren 5a bis c. Objekt- und Bildebene der Figur 3 können selbstverständlich miteinander vertauscht werden.

Figur 4a zeigt ein Objektiv für die Abbildung von oder nach Unendlich. Es besteht aus den Ellipsoiden 4a und 4b mit den Mantelflächen 40 und 45. Auch in diesem Fall ist es für die Abbildungseigenschaften günstiger, die inneren Brennpunkte 42 und 47 der Ellipsoide nicht zusammen zu legen und die Bildebene 4e, welche durch den Mittelpunkt 49 der Kugelfläche 48 geht, nicht durch den äußeren Brennpunkt 46 zu legen. Die äußere Kugelfläche 43 des Ellipsoides 4a hat praktisch einen unendlich großen Radius und ist daher praktisch eben.

Die Abbildung von oder nach Unendlich ist auch durch die in Figur 4b dargestellte Kombination von einem Paraboloid 4a' mit der Mantelfläche 40' und einem Ellipsoid 4b' mit der Mantelfläche 45' möglich. In diesem Fall ist es zweckmäßig, den Brennpunkt 42' des Paraboloides 4a' mit dem inneren Brennpunkt 47' des Ellipsoides 4b' zusammen zu legen und die Bildebene 4e', welche durch den Mittelpunkt 49' der Kugelfläche 48'
geht, durch den äußeren Brennpunkt 46' des Ellipsoides 4b' zu legen. Die
in Figur 4b dargestellte Kombination von Paraboloid 4a' und Ellipsoid
4b' hat gegenüber der in Figur 4a dargestellten Kombination aus zwei
Ellipsoiden 4a und 4b den Nachteil, daß sie größere Abbildungsfehler hat
und sehr justierempfindlich ist.

In den bisher besprochenen Figuren sind die Mantelflächen z.B. 10,15
oder 40',45' so gezeichnet, daß sie unmittelbar ineinander übergehen.
Für die Herstellung derartiger Kegelschnittflächen ist es eine Erleichterung, wenn die Flächen am Anfang und am Ende Bereiche haben, welche
optisch nicht mehr ausgenutzt werden und daher nicht mehr exakt stimmen
müssen. In den Figuren 5a bis 5c haben daher die Ellipsoide 5a und 5b
außerhalb der von der äußeren Apertur 54 ausgenutzten Bereiche der Mantelflächen 50 und 55 an den Außenseiten Bereiche 5f und 5f', die so groß
gemacht werden können, wie es für die Bearbeitung und die Halterung der
Ellipsoide vorteilhaft ist. Die Bereiche 5g und 5g' an den Innenseiten
können zunächst ebenfalls so groß gemacht werden, wie es für die Herstellung der Mantelflächen im optisch ausgenutzten Bereich günstig ist.
In einem weiteren Herstellungsgang erhalten die Ellipsoide 5a und 5b
dann bei dem in Figur 5a gezeigten Ausführungsbeispiel Planflächen 5h
und 5h'. Diese gehen durch die Brennpunkte 52 und 57, wenn die fertigen
Ellipsoide aneinander angesprengt werden. Sollen die Ellipsoide miteinander verkittet werden, dann werden die Planflächen 5h und 5h' entsprechend tiefer gearbeitet.

Figur 5b zeigt eine andere Ausführungsform für den Übergang zwischen den
beiden Ellipsoiden 5a und 5b. In diesem Fall besteht keine direkte Verbindung sondern der Übergang erfolgt mit einem kugelförmigen Luftzwischenraum 58. Sein Mittelpunkt fällt mit den beiden inneren Brennpunkten
52 und 57 der Ellipsoide 5a und 5b zusammen, so daß für alle Strahlen,
die durch diese Brennpunkte gehen, keine Ablenkung erfolgt.

Eine vorteilhafte Ausführungsform für den Übergang zwischen den beiden
Ellipsoiden 5a und 5b zeigt Figur 5c. Hier erfolgt die Verbindung durch
eine Glaskugel 59, deren Mittelpunkt ebenfalls mit den beiden inneren
Brennpunkten 52 und 57 zusammenfällt. Es ist besonders vorteilhaft, die Kugel aus einem Material mit großer Brechzahl, z.B. aus Saphir, zu machen, da sich so die Bildfehler für Punkte außerhalb der Brennpunkte besonders klein machen lassen. Das betrifft insbesondere die Bildfeldwölbung, die auf diese Art gegenüber der Luftkugel um den Faktor 6 und gegenüber einer Verbindung aus Material mit gleicher Brechzahl um den Faktor 2,3 reduziert wird.

Das in Figur 5c gezeigte Ausführungsbeispiel für den Abbildungsmaßstab 1:1 kann z.B. mit folgenden Daten ausgeführt werden:

große Halbachse der Ellipsoide 34,93 mm

kleine Halbachse der Ellipsoide 12,81 mm

numerische Exzentrizität 0,93032605

Abstand der äußeren Brennpunkte 129,985 mm

Radius der äußeren Kugelflächen 45,316 mm

Radius der inneren Kugelflächen 4,732 mm

Mittendicke der Ellipsiode 14,945 mm

Aperturwinkel 12,5°

Material der Ellipsoide Suprasil

Material der Kugel Saphir.

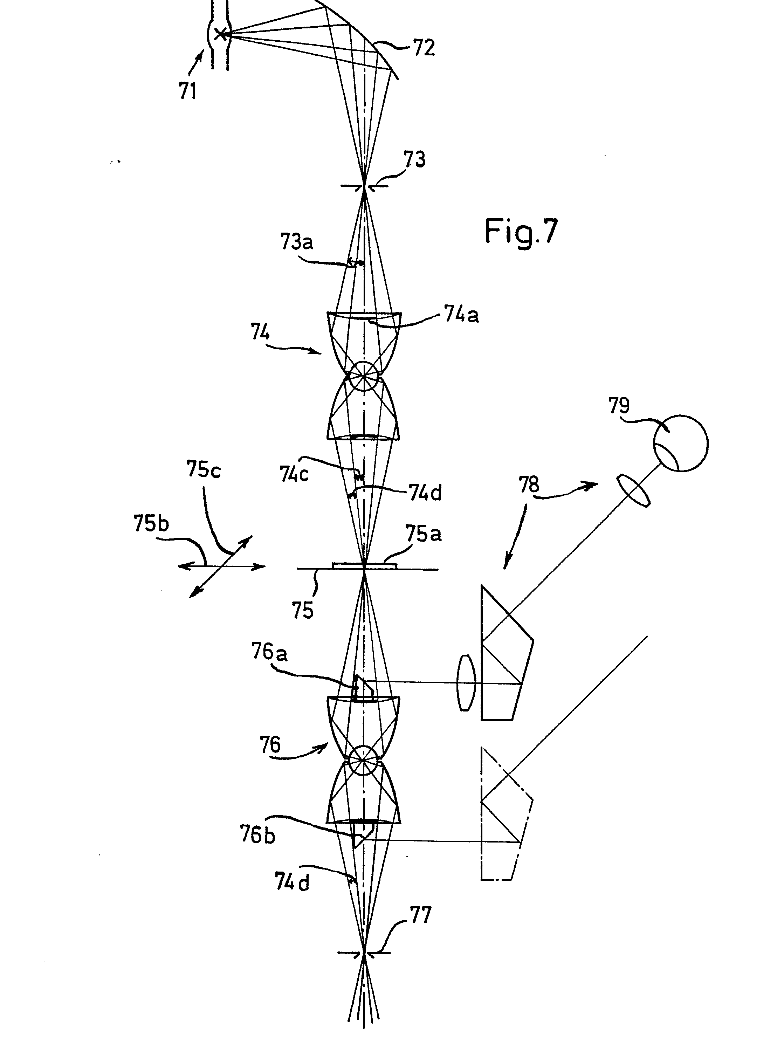

Bei diesem Objektiv beträgt für einen in der Objektebene in 1 mm Abstand vom Brennpunkt liegenden Objektpunkt die Abweichung von der Bildebene infolge der Bildfeldkrümmung 0,15 mm. Zwei Objektive mit diesen Daten werden für den mit Figur 7 beschriebenen Strahlengang für ein Spektrometer benutzt.

Das in Figur 3 für den Abbildungsmaßstab 3:1 dargestellte Objektiv kann z.B. mit folgenden Daten ausgeführt werden, wobei zwischen den beiden Ellipsoiden eine Saphirkugel entsprechend Fig. 5c angeordnet ist:

große Halbachse des Ellipsoides 3a 99,454 mm

kleine Halbachse des Ellipsoides 3a 21,603 mm

numerische Exzentrizität des Ellipsoides 3a 0,9761241

große Halbachse des Ellipsoides 3b 34,93 mm

kleine Halbachse des Ellipsoides 3b 12,81 mm

numerische Exzentrizität des Ellipsoides 3b 0,93032605

Abstand der äußeren Brennpunkte 259,152 mm

Radius der Kugelfläche 33 178,635 mm

Radius der Kugelfläche 38 45,316 mm

Radius der inneren Kugelflächen 4,7315 mm

Abstand Brennpunkt 31 zu Kugelflächenmittelpunkt 34 2,17 mm

Abstand Brennpunkt 36 zu Kugelflächenmittelpunkt 39 0,45 mm

Abstand der inneren Brennpunkte 32,37 0,13 μm

Mittendicke des Ellipsoides 3a 14,945 mm

Mittendicke des Ellipsoides 3b 14,945 mm

Aperturwinkel des Ellipsoides 3a 4,16°

Aperturwinkel des Ellipsoides 3b 12,5°

Material der Ellipsoide Suprasil

Material der Kugel Saphir.


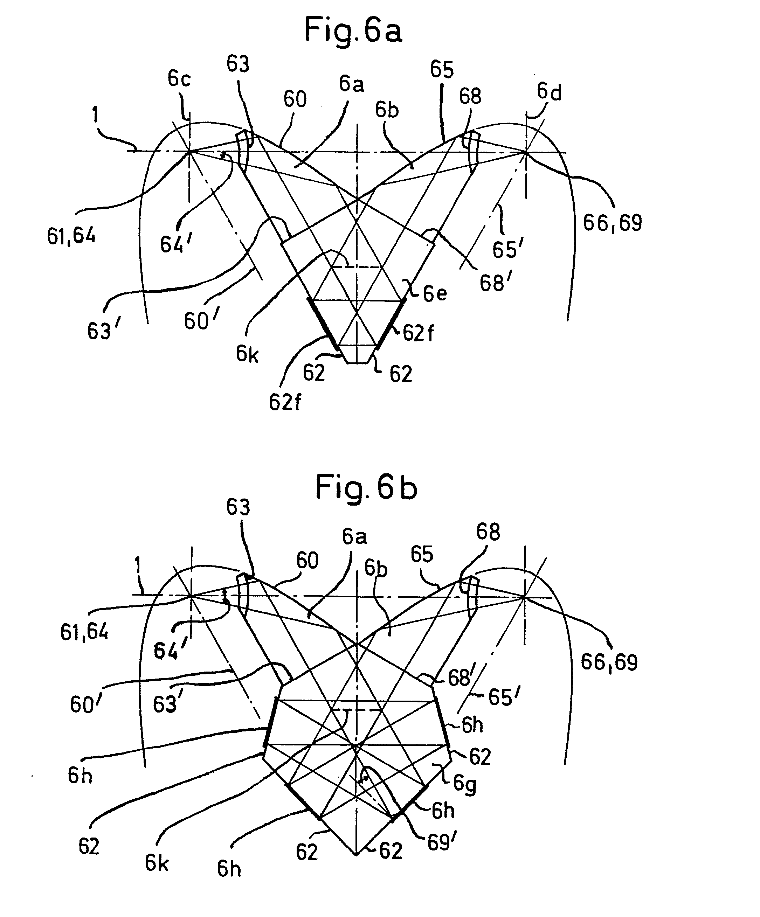

In den Figuren 6a und b sind Objektive dargestellt, bei denen beide Kegelschnittkörper Paraboloide sind. Die Achsen 60' und 65' der Paraboloide 6a und 6b sind zur optischen Achse 1 des Gesamtsystems geneigt. Dies hat den Vorteil, daß keine innere Apertur ausgeblendet werden muß; das System hat gute Abbildungseigenschaften jedoch nur für den Abbildungsmaßstab 1:1. Außerdem müssen - für ein geradsichtiges Objektiv - eine gerade Anzahl von reflektierenden Planflächen 62 so angeordnet sein, daß das parallele Strahlenbündel vor der ersten und nach der letzten reflektierenden Planfläche sich selbst, z.B. an der mit 6k bezeichneten Stelle, kreuzt. Dann ergibt eine gedachte Aufwicklung des Strahlenganges, daß sich die beiden parabolischen Mantelflächen 60 und 65 achsialsymmetrisch gegenüberstehen und somit als aplanatisches System wirksam werden. Die Paraboloide 6a und 6b werden auf der Eingangs- und Ausgangsseite durch die Kugelflächen 63 und 68 begrenzt, deren Mittelpunkte 64 und 69 mit den Brennpunkten 61 und 66 der Paraboloide zusammenfallen, und die somit für die Brennpunkte aplanatische Flächen darstellen. Die Objektebene ist mit 6c und die Bildebene mit 6d bezeichnet. Die inneren Kugelflächen 63' und 68' der Paraboloide haben einen Radius von Unendlich, d.h. sie sind Planflächen. Sie verlaufen senkrecht zu den ein- bzw. austretenden Parallellichtbündeln.

In Figur 6a ist zwischen den beiden Planflächen 63' und 68' ein Glaskörper 6e angeordnet, dessen reflektierende Planflächen 62 Spiegelschichten

62f enthalten. Statt dessen könnten natürlich auch zwei einzelne Planspiegel an den entsprechenden Stellen verwendet werden, was allerdings
zu keinem so kompakten Aufbau führen würde, wie er in Figur 6a dargestellt ist.

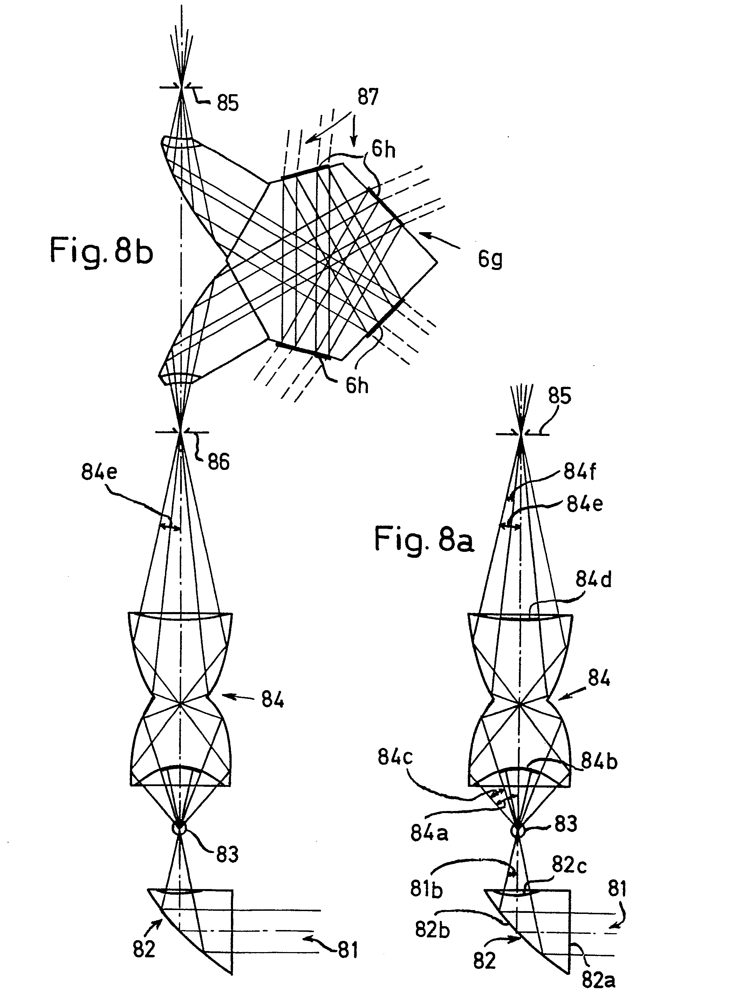

In Figur 6b ist zwischen den beiden Planflächen 63' und 68' ein Glaskörper 6g mit 4 reflektierenden Flächen 62 angeordnet. Durch die größere
Anzahl von reflektierenden Flächen 62 ist der Einfallswinkel 69' der an
den Flächen 62 reflektierenden Strahlen so klein, daß dort Interferenzschichten 6h wirksam eingesetzt werden können, durch welche z.B. ein
schmaler Wellenlängenbereich nicht reflektiert und damit durch das Spiegelobjektiv nicht durchgelassen wird. Ein Anwendungsbeispiel für ein
derartiges Objektiv wird später mit Figur 8b beschrieben.

Zunächst wird ein Anwendungsbeispiel für das mit Figur 5c beschriebene
Objektiv gebracht, für das weiter oben im Text die genauen Daten angegeben sind. Figur 7 zeigt zwei derartige Objektive im Probenraum eines
Spektrometers. Mit 71 ist eine Lichtquelle, z.B. eine Xenonlampe, bezeichnet, welche durch den asphärischen Hohlspiegel 72 auf eine Blende
73 abgebildet wird, die z.B. einen veränderbaren Durchmesser von 25, 50
oder 100 µm hat. Diese Blende wird durch das Spiegelobjektiv 74 in die
Probenebene 75 im Maßstab 1:1 abgebildet, in der die Probe 75a in den
Richtungen 75b und 75c senkrecht zur optischen Achse verschoben werden
kann.

Durch ein zweites Spiegelobjektiv 76 wird die Probenebene 75 auf den
Eintrittsspalt 77 eines Diodenzeilen-Spektrometers abgebildet. Dieses
Diodenzeilen-Spektrometer hat einen Öffnungswinkel von 12,5°, welcher
durch die äußere Apertur 74d der Spiegelobjektive 74 und 76 voll ausgenutzt wird, wobei von der Gesamtapertur 73a durch die notwendige Blende
74a lediglich der flächenmäßig kleine Anteil der inneren Apertur 74c
ausgeblendet wird.

Innerhalb der inneren Apertur 74c sind auf das zweite Spiegelobjektiv 76
Glaszylinder 76a und 76b mit reflektierenden Oberflächen, welche um 45°
zur optischen Achse geneigt sind, aufgesetzt, über die mit Hilfe der
Beobachtungseinrichtung 78 vom Auge 79 entweder beobachtet werden kann, welcher Ausschnitt der Probe 75a im Strahlengang ist, oder kontrolliert werden kann, wie die Ausleuchtung des Eintrittsspaltes 77 des Spektrometers ist.

Ein Vorteil der beschriebenen Anordnung gegenüber bekannten Kombinationen von Mikroskop und Photometer ist nicht nur, daß ein ganzes Spektrum wesentlich schneller aufgenommen wird, sondern vor allem daß nur der Bereich der Probe beleuchtet wird, der gerade gemessen wird, und dadurch das von anderen Bereichen der Probe verursachte Streulicht vermieden wird.

Als weiteres Anwendungsbeispiel ist in Figur 8a der Strahlengang im Probenraum eines Fluoreszenz-Spektrometers dargestellt, bei dem durch ein Spiegelobjektiv mit zwei verschiedenen Ellipsoiden eine von der Probenstrahlung ausgenutzte große Apertur auf diejenige des Spektrometers reduziert wird. In Fig. 8a ist mit 81 die Strahlung eines (nicht dargestellten) Lasers bezeichnet, die von dem optischen Element 82 auf die Probe 83 mit dem Öffnungswinkel 81b konzentriert wird. Das optische Element besteht aus einem Glasteil mit einer planen Eintrittsfläche 82a, einer reflektierenden parabolischen Fläche 82b und einer kugelförmigen Austrittsfläche 82c. Der Brennpunkt der parabolischen Fläche 82b und der Mittelpunkt der kugelförmigen Austrittsfläche 82c liegen im Mittelpunkt der Probe 83.

Auf der anderen Seite der Probe 83 ist das Spiegelobjektiv 84 so angeordnet, daß der äußere Brennpunkt des 1. Ellipsoides im Mittelpunkt der Probe 83 liegt und somit die Blende 84b, die in diesem Fall als Spiegel ausgebildet ist, die von der Probe 83 nicht absorbierte Laserstrahlung wieder in die Probe zurück reflektiert. Der Öffnungswinkel 81b der Laserstrahlung wird zweckmäßigerweise kleiner gewählt als es dem Durchmesser der Blende bzw. dem Spiegel 84b entspricht, damit auch noch nach vorne gestreute Laserstrahlung von der Blende 84b erfaßt wird.

Das Objektiv 84 bildet die Probe 83 auf den Eintrittsspalt 85 eines bekannten Diodenzeilen-Spektrometers ab und verkleinert dabei den Öffnungswinkel 84a auf den Öffnungswinkel 84e, der ebenso groß ist wie der Öffnungswinkel des Spektrometers, wobei jeweils nur die äußeren Aperturen 84c und 84f ausgenutzt werden.

Es ist selbstverständlich auch möglich, den Öffnungswinkel an denjenigen eines konventionellen Spektrometers anzupassen; dazu müßte das Objektiv nur anders dimensioniert werden.

Figur 8b zeigt den Strahlengang eines Raman-Spektrometers, der im Anfang zunächst vollständig mit dem des in Figur 8a gezeigten Strahlengang des Fluoreszenz-Spektrometers übereinstimmt. Nach dem Objektiv 84 kommt in dessen Bildebene jedoch noch nicht der Eintrittsspalt sondern eine Zwischenblende 86. Diese wird durch das mit Figur 6b beschriebene Objektiv 87 auf den Eintrittsspalt 85 des Diodenzeilen-Spektrometers abgebildet. Durch das Objektiv 87 wird der Öffnungswinkel 84e natürlich nicht verändert, so daß er auch in diesem Fall optimal an den des Spektrometers angepaßt ist. Die schmalbandigen Interferenzfilterschichten 6h haben für die Anregungswellenlänge einen sehr niederen Reflexionsgrad und einen hohen Durchlaßgrad während sie für das zu untersuchende Ramanspektrum einen hohen Reflexionsgrad aufweisen. Durch die vier aufeinander folgenden Interferenzfilterschichten 6h wird daher die Anregungswellenlänge dadurch sehr stark unterdrückt, daß das Licht dieser Wellenlänge aus dem Glaskörper 6g austritt, während das Nutzlicht des Ramanspektrums mit hohem Reflexionsgrad auf den Eintrittsspalt 85 des Diodenzeilen-Spektrometers abgebildet wird.

Patentansprüche:

1. Objektiv mit reflektierenden Kegelschnittflächen, dadurch gekennzeichnet, daß die reflektierenden Kegelschnittflächen Mantelflächen (z.B. 10,15,40,45,60,65) von optisch isotropen Kegelschnittkörpern (z.B. 1a,1b,4a,4b,6a,6b) sind und daß die Lichtein- und austrittsflächen (z.B. 13,18,43,48,63,68) der Kegelschnittkörper (z.B. 1a,1b,4a,4b,6a,6b) Kugelflächen sind, deren Mittelpunkte (z.B. 14,19,49,49',64,69) mit den Brennpunkten (z.B. 11,16,46,46',61,66) der Kegelschnittkörper (z.B. 1a,1b,4a,4b,6a,6b) mindestens annähernd in einem Punkt vereinigt sind.

2. Objektiv nach Anspruch 1, dadurch gekennzeichnet, daß die Kegelschnittkörper Ellipsoide (z.B. 1a,1b,4a,4b) sind, deren Brennpunkte auf einer Achse (1) angeordnet sind und deren innere Brennpunkte (z.B. 12,17 und 42,47) mindestens annähernd in einem Punkt vereinigt sind.

3. Objektiv nach Anspruch 1, dadurch gekennzeichnet, daß die Kegelschnittkörper ein Ellipsoid (4b') und ein Paraboloid (4a') sind, deren Brennpunkte (46',47',42') auf einer Achse (1) angeordnet sind, wobei der Brennpunkt (42') des Paraboloides (4a') mit einem Brennpunkt (47') des Ellipsoides (4b') in einem Punkt vereinigt ist, und daß der Mittelpunkt der äußeren Kugelfläche (43') des Paraboloides (4a') im Unendlichen ist.

4. Objektiv nach Anspruch 2 oder 3, dadurch gekennzeichnet, daß beide Kegelschnittkörper (z.B. 1a,1b und 5a,5b) direkt miteinander verbunden sind.

5. Objektiv nach Anspruch 2 oder 3, dadurch gekennzeichnet, daß zwischen beiden Kegelschnittkörpern (5a,5b) ein kugelförmiger Luftzwischenraum (58) angeordnet ist, dessen Mittelpunkt mit den inneren Brennpunkten (52,57) der Kegelschnittkörper (5a,5b) mindestens annähernd in einem Punkt vereinigt ist.

6. Objektiv nach Anspruch 2 oder 3, dadurch gekennzeichnet, daß zwischen beiden Kegelschnittkörpern (5a,5b) eine Kugel (59) aus optisch isotropen Material angeordnet ist, deren Mittelpunkt mit den Brennpunkten (52,57) der Kegelschnittkörper (5a,5b) mindestens annähernd in einem Punkt vereinigt ist.

7. Objektiv nach Anspruch 6, dadurch gekennzeichnet, daß die Brechzahl der Kugel (59) größer als die Brechzahl der Kegelschnittkörper (5a, 5b) ist.

8. Objektiv nach Anspruch 1, dadurch gekennzeichnet, daß die Kegelschnittkörper zwei Paraboloidausschnitte (6a,6b) sind, deren Achsen (60',65') zur optischen Achse (1) des Abbildungssystemes geneigt sind, daß die Mittelpunkte (64,69) der äußeren Kugelflächen (63,68) mit den Brennpunkten (61,66) der Paraboloidausschnitte (6a,6b) in einem Punkt vereinigt sind, daß die Mittelpunkte der inneren Kugelflächen (63',68') im Unendlichen sind und daß zwischen den Paraboloidausschnitten (6a,6b) eine gerade Anzahl von reflektierenden Planflächen (62) so angeordnet ist, daß das zwischen den Paraboloidausschnitten (6a,6b) verlaufende parallele Strahlenbündel sich vor der ersten und nach der letzten reflektierenden Planfläche (62) kreuzt.

9. Objektiv nach Anspruch 8, dadurch gekennzeichnet, daß mindestens ein Teil der reflektierenden Flächen (62) mit Interferenzschichten (62h) belegt ist.

10. Objektiv nach einem der Ansprüche 1 bis 9, gekennzeichnet durch seine Anwendung für optische Meßgeräte, insbesondere für Spektrometer.

# Fig.1

# Fig. 2

Fig.3

Fig.4a

Fig.4b

Fig. 5a

Fig. 5b

Fig. 5c

## Fig. 6a

## Fig. 6b

0144950

Fig.7

0144950

Fig. 8b

Fig. 8a